Europäisches Patentamt

European Patent Office

Office européen des brevets

(11) Veröffentlichungsnummer: **0 357 868**
**A1**

## EUROPÄISCHE PATENTANMELDUNG

(21) Anmeldenummer: **89107364.5**

(22) Anmeldetag: **24.04.89**

(51) Int. Cl.5 **G01R 11/58**

(30) Priorität: **08.09.88 CH 3369/88**

(43) Veröffentlichungstag der Anmeldung:
**14.03.90 Patentblatt 90/11**

(84) Benannte Vertragsstaaten:
**AT CH DE GR LI NL**

(71) Anmelder: **Landis & Gyr Betriebs AG**

**CH-6301 Zug(CH)**

(72) Erfinder: **Macquaire, Patrice**
**Rue de la Lombardie 15**
**F-03100 Montluçon(FR)**

(54) **Elektrizitätszähler mit einem Zwei- oder Mehrtarifzählwerk.**

(57) Ein Elektrizitätszähler (18) weist einen eingebauten Rundsteuerempfänger (19) und ein kombiniertes Relais (20) auf. Im kombinierten Relais (20) sind ein Ausgangsrelais des Rundsteuerempfängers (19) und ein Tarifumschaltelement eines Zweitarifzählwerkes (2) zusammengefasst. Das vorzugsweise bistabil ausgeführte kombinierte Relais (20) wirkt über einen Anker (22) einerseits auf einen Stössel (11) und andererseits auf einen Signalkontakt (23). Vom Stössel (11) wird die Tarifumschalteinrichtung des Zweitarifzählwerkes (2) betätigt. Das kombinierte Relais (20) ermöglicht eine kostengünstige, platzsparende Ausführung.

EP 0 357 868 A1

Fig. 3

## Elektrizitätszähler mit einem Zwei- oder Mehrtarifzählwerk

Die Erfindung bezieht sich auf einen Elektrizitätszähler mit einem Zwei- oder Mehrtarifzählwerk gemäss dem Oberbegriff des Anspruchs 1.

Es ist ein Elektrizitätszähler mit einem Zweitarifzählwerk und einem Tarifumschaltelement, bei dem die Tarifumschaltung vom Ausgangsrelais eines eingebauten Rundsteuerempfängers steuerbar ist, bekannt (Prospektschrift der Anmelderin, "Compteur Extérieur CM 169). Die Aufgabe des Rundsteuerempfängers besteht darin, die auf dem 50-Hz-Versorgungsnetz übertragenen tonfrequenten Impulse zu empfangen und in Befehle umzusetzen. Ueber die Rundsteuerung werden die Umschaltung des Zweitarifzählwerkes und weitere Funktionen gesteuert.

Zweitarifzählwerke besitzen zwei Rollenzählwerke, die wechselweise an das Triebsystem des Elektrizitätszählers angeschlossen werden. Dies ermöglicht den Verbrauch von elektrischer Energie zu getrennten Zeiten zu erfassen. Als Beispiel sei die Zählung der verbrauchten Energie nach Tag- und Nachttarif genannt. Die Umschaltung von einem Rollenzählwerk zum anderen erfolgt mit einem Tarifumschaltelement. Je nach Zustand einer Steuergrösse wird der Strom in einer Magnetspule an- oder abgeschaltet. Der Anker wird entsprechend angezogen oder er fällt ab. Ueber eine geeignete mechanische Einrichtung wird der Antrieb entweder auf das eine oder das andere Rollenzählwerk geschaltet (DE-AS 2 150 412). Es werden verhältnismässig teure Bauteile wie die Magnetspule und der Anker benötigt. Ausserdem ist der Energieverbrauch in der Zeit, in der dasjenige Rollenzählwerk läuft, das angetrieben wird, wenn in der Magnetspule Strom fliesst, gross.

Rundsteuerempfänger bestehen im wesentlichen aus den drei Baugruppen Eingangsteil, Auswerteteil und Ausgangsteil (Prospektschrift "Rundsteuerempfänger FTT" von Landis & Gyr). Im Eingangsteil befinden sich Filter, welche die tonfrequenten Impulse aus dem 50-Hz-Versorgungsnetz herausfiltern. Die Impulse werden im Auswerteteil mit Hilfe eines Mikroprozessors in Befehle umgesetzt. Diese Befehle steuern schliesslich die elektromagnetischen Ausgangsrelais, die im Ausgangsteil angeordnet sind.

Der Erfindung liegt die Aufgabe zugrunde, eine kostengünstige, platzsparende Anordnung zur Steuerung eines Zweitarifzählwerkes mit Hilfe eines Rundsteuerempfängers zu schaffen.

Die Erfindung besteht in den im Kennzeichen des Anspruchs 1 angegebenen Merkmalen. Vorteilhafte Ausgestaltungen ergeben sich aus den Unteransprüchen.

Nachfolgend wird ein Ausführungsbeispiel der Erfindung anhand der Zeichnungen näher erläutert.

Es zeigen:

Fig. 1 einen Elektrizitätszähler mit einem Zweitarifzählwerk und einem räumlich getrennten Rundsteuerempfänger üblicher Bauart,

Fig. 2 eine schwenkbare Achse eines Zweitarifzählwerkes, und

Fig. 3 einen Elektrizitätszähler mit einem Zweitarifzählwerk und einem eingebauten Rundsteuerempfänger.

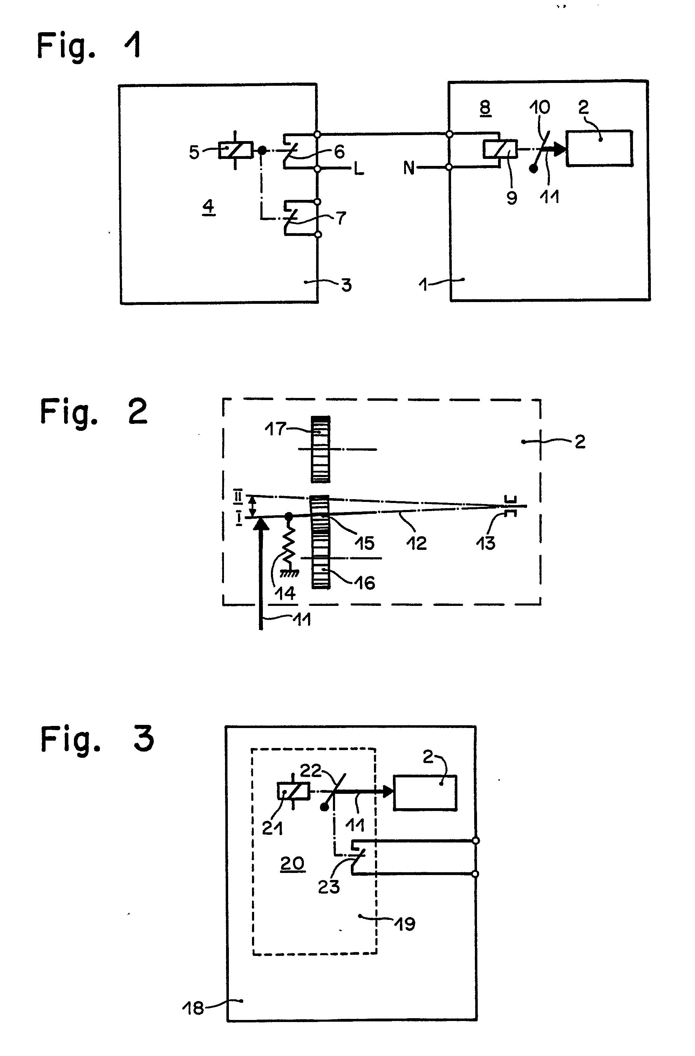

Die Fig. 1 zeigt den Stand der Technik bei der Steuerung eines in einen Elektrizitätszähler 1 eingebauten Zweitarifzählwerkes 2 durch einen Rundsteuerempfänger 3. Im Detail eingezeichnet ist im Rundsteuerempfänger 3 ein Ausgangsrelais 4 mit einer Spule 5 und zwei Signalkontakten 6 und 7. Im Elektrizitätszähler 1 sind ein Tarifumschaltelement 8 mit einer Spule 9, einem Anker 10 und einem Stössel 11 und das Zweitarifzählwerk 2 eingezeichnet. Der Signalkontakt 6 des Ausgangsrelais 4 ist mit der Spule 9 des Tarifumschaltelementes 8 elektrisch verbunden. Bei geschlossenem Signalkontakt 6 wird die Spule 9 erregt und der Anker 10 wird angezogen. Bei offenem Signalkontakt 6 ist die Spule 9 nicht erregt und der Anker 10 wird entsprechend freigegeben. Eine hier nicht gezeichnete Rückstellfeder bewegt den Anker 10 in die offene Stellung zurück. Der Anker 10 wirkt über den Stössel 11 auf die Umschalteinrichtung des Zweitarifzählwerkes 2. Der Rundsteuerempfänger 3 kann in einem eigenen Gehäuse oder im Gehäuse des Elektrizitätszählers 1 eingebaut sein.

Die Fig. 2 zeigt eine gebräuchliche Umschalteinrichtung eines Zweitarifzählwerkes 2. Die wesentlichsten Funktionselemente sind eine schwenkbare Achse 12, ein festes Lager 13, eine Feder 14, Zahnräder 15, 16 und 17 und ein Stössel 11. Die Achse 12 wird vom Elektrizitätszähler über hier nicht gezeichnete Zahnräder angetrieben. Die eine Seite der Achse 12 ist im Lager 13 fest gelagert. Die andere Seite der Achse 12 ist beweglich und wird von der Feder 14 in die Position I gezogen. In der Position I sind die Zahnräder 15 und 16 im Eingriff. Vom Stössel 11 kann die Achse 12 entgegen der Kraft der Feder 14 in die Position II bewegt werden. In der Position II sind die Zahnräder 15 und 17 im Eingriff. Von den Zahnrädern 16 und 17 werden zwei, hier nicht gezeichnete, Rollenzählwerke angetrieben, die den Energieverbrauch im Hoch- und im Niedertarif anzeigen. Der Stössel 11 wird vom Anker eines Tarifumschaltelementes bewegt.

Die Fig. 3 zeigt blockschemamässig einen Elektrizitätszähler 18 mit einem Zweitarifzählwerk 2 und einem eingebauten Rundsteuerempfänger 19.

Im weiteren ist ein kombiniertes Relais 20 mit einer Spule 21, einem Anker 22, einem Signalkontakt 23 und einem Stössel 11 eingezeichnet. Die Spule 21 ist unmittelbar an die nicht gezeichnete Elektronik des Rundsteuerempfängers 19 angeschlossen. Von der Spule 21 wird der Anker 22 elektromagnetisch betätigt. Bei erregter Spule 21 wird der Anker 22 entgegen der Kraft einer hier nicht gezeichneten Rückstellfeder angezogen. Bei nicht erregter Spule 21 wird der Anker 22 freigegeben und fällt ab. Die Bewegung des Ankers 22 wird über den Stössel 11 auf die Umschalteinrichtung des Zweitarifzählwerkes 2 übertragen. Im kombinierten Relais 20 sind also sowohl das Ausgangsrelais des Rundsteuerempfängers 19 wie auch das Tarifumschaltelement des Zweitarifzählwerkes 2 zusammengefasst. Dadurch, dass der Rundsteuerempfänger 19 im Elektrizitätszähler 18 eingebaut oder in unmittelbarer Nähe des Elektrizitätszählers 18 angeordnet ist, ist man auch in der Wahl des Relaistypes frei. Das üblicherweise bistabile Ausgangsrelais des Rundsteuerempfängers 19 und das monostabile Tarifumschaltelement des Zweitarifzählwerkes 2 lassen sich in einem monostabilen oder einem bistabilen kombinierten Relais 20 zusammenfassen. In bistabiler Ausführung kann das kombinierte Relais 20 als Remanenzrelais mit nur einer Spule 21 oder mit je einer separaten Ein- und Ausschaltspule ausgeführt sein. Vorteilhaft wird vom Anker 22 gleichzeitig mit der Tarifumschaltung auch ein Signalkontakt 23 betätigt. Die Anschlüsse des Signalkontaktes 23 sind aus dem Gehäuse des Elektrizitätszählers 18 nach aussen geführt. Der Signalkontakt 23 kann vielseitig eingesetzt werden. Als Beispiel sei die Steuerung der Zweitarifzählwerke einer ganzen Gruppe von nicht mit Rundsteuerempfängern ausgerüsteten Elektrizitätszählern genannt.

Mit der beschriebenen Anordnung sind einige Vorteile verknüpft:

- Durch den Wegfall eines Relais ergeben sich Kostenvorteile.

- Bei der üblichen gedrängten Bauweise von modernen Geräten ist der Wegfall einer solch voluminösen Baugruppe, wie es ein Relais darstellt, wesentlich.

- Durch den Ersatz des monostabilen Tarifumschaltelementes durch ein bistabiles, kombiniertes Relais wird Energie eingespart. Bei den unzähligen im Betriebe stehenden Elektrizitätszählern ist dies von ausserordentlich grosser Bedeutung.

Natürlich ist eine solche Anordnung nicht nur auf Zweitarifzählwerke 2 mit schwenkbarer Achse 12 als Umschalteinrichtung beschränkt. Das kombinierte Relais 20 kann bei allen mechanischen Tarifgeräten eingesetzt werden, z. B. auch bei solchen mit Differentialgetriebe als Umschalteinrichtung. Mit mehreren kombinierten Relais 20 im Ausgangsteil eines Rundsteuerempfängers 19 lassen sich auch kompliziertere Tarifgeräte wie z.B. Dreifachtarife oder Maximumtarife steuern.

## Ansprüche

1. Elektrizitätszähler (18) mit einem Zwei- oder Mehrtarifzählwerk (2) und einem Tarifumschaltelement (8), bei dem die Tarifumschaltung vom Ausgangrelais (4) eines Rundsteuerempfängers (3; 19) steuerbar ist, dadurch gekennzeichnet, dass das Ausgangsrelais (4) des Rundsteuerempfängers (3; 19) und das Tarifumschaltelement (8) des Zwei- oder Mehrtarifzählwerkes (2) in einem kombinierten Relais (20) zusammengefasst sind.

2. Elektrizitätszähler (18) nach Anspruch 1, dadurch gekennzeichet, dass das kombinierte Relais (20) aus einer Spule (21), einem von der Spule (21) elektromagnetisch betätigten Anker (22) und einem Stössel (11) zwischen Anker (22) und Umschalteinrichtung des Zweitarifzählwerkes (2) besteht.

3. Elektrizitätszähler (18) nach einem der vorangehenden Ansprüche, dadurch gekennzeichnet, dass das kombinierte Relais (20) bistabil ist.

4. Elektrizitätszähler (18) nach einem der vorangehenden Ansprüche dadurch gekennzeichnet, dass das kombinierte Relais (20) einen oder mehrere Signalkontakte (23) aufweist, die gleichzeitig mit der Tarifumschaltung betätigt werden.

5. Elektrizitätszähler (18) nach Anspruch 4, dadurch gekennzeichnet, dass die Anschlüsse der Signalkontakte (23) aus dem Gehäuse des Elektrizitätszählers (18) nach aussen geführt sind.

6. Elektrizitätszähler (18) nach einem der vorangehenden Ansprüche, dadurch gekennzeichnet, dass das Mehrtarifzählwerk von mehreren kombinierten Relais (20) gesteuert wird.

7. Elektrizitätszähler (18) nach Anspruch 1, dadurch gekennzeichnet, dass der Rundsteuerempfänger (19) im Gehäuse des Elektrizitätszählers (18) eingebaut ist.

# Fig. 1

L

N

5  6  7  8  9  10  11  2

4

3  1

# Fig. 2

17

II
I

15  12  13

14  16

11

2

# Fig. 3

22  2

21  11

20

23

19

18

**Europäisches Patentamt**

# EUROPÄISCHER RECHERCHENBERICHT

Nummer der Anmeldung

EP 89 10 7364

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | FR-A-2 214 893 (LICENTIA) * Seite 2, Zeilen 20-35; Seite 3, Zeilen 3-12; Figur 1 * | 1,7 | G 01 R 11/58 |
| Y | --- | 2,3,6 | |
| Y | CH-A- 128 034 (LANDIS & GYR) * Seite 2, rechte Spalte, Absatz 2 * | 2 | |
| A | --- | 1 | |
| Y | DE-A-1 498 192 (SIEMENS) * Seite 1, Absätze 1-2 * | 3 | |
| A | --- | 1 | |
| Y | DE-B-1 160 094 (LICENTIA) * Spalte 2, Zeile 52 - Spalte 3, Zeile 5 * | 6 | |
| A | ----- | 1 | |

**RECHERCHIERTE SACHGEBIETE (Int. Cl.5)**

G 01 R

Der vorliegende Recherchenbericht wurde für alle Patentansprüche erstellt

| Recherchenort | Abschlußdatum der Recherche | Prüfer |
|---|---|---|
| DEN HAAG | 20-09-1989 | SINAPIUS G.H. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes
    Dokument

EPO FORM 1503 03.82 (P0403)